# EUROPÄISCHE PATENTANMELDUNG

(11) **EP 1 835 538 A1**
(43) Veröffentlichungstag der Anmeldung: **19.09.2007**
(21) Anmeldenummer: 07005114.9
(22) Anmeldetag: 13.03.2007
(51) Int. Cl.: H01L 25/11

(54) **Elektronisches Bauelement, elektronische Baugruppe sowie Verfahren zur Herstellung einer elektronischen Baugruppe**

(30) Priorität: 18.03.2006 DE 102006012600
(71) Anmelder: ATMEL Germany GmbH, 74072 Heilbronn (DE)
(72) Erfinder: Fischer, Harald, 56338 Braubach/Rhein (DE); Motz, Martin, 74074 Heilbronn (DE); Mutz, Dieter, 74078 Heilbronn (DE)

(57) **Zusammenfassung**

Die Erfindung betrifft ein elektronisches Bauelement mit zumindest einer integrierten Schaltung, die in einem formstabilen Kunststoffgehäuse aufgenommen ist und die elektrisch leitend mit zumindest einer elektrisch leitfähigen, von außen am Kunststoffgehäuse zugänglichen Kontaktzunge verbunden ist, eine elektronische Baugruppe mit einem derartigen elektronischen Bauelement sowie ein Verfahren zur Herstellung einer elektronischen Baugruppe

Erfindungsgemäß ist vorgesehen, dass an dem Kunststoffgehäuse zumindest eine, insbesondere als Vertiefung ausgeführte, Ausnehmung vorgesehen ist, in der zumindest eine Kontaktzunge freiliegend angeordnet ist.

Verwendung für Elektronikbauteile

## Beschreibung

Die Erfindung betrifft ein elektronisches Bauelement mit zumindest einer integrierten Schaltung, die in einem formstabilen Kunststoffgehäuse aufgenommen ist und die elektrisch leitend mit zumindest einer elektrisch leitfähigen, von außen am Kunststoffgehäuse zugänglichen Kontaktzunge verbunden ist; eine auf dem elektronischen Bauelement basierende elektronische Baugruppe sowie ein Verfahren zur Herstellung einer elektronischen Baugruppe.

Elektronische Bauelemente sind aus dem Stand der Technik in unterschiedlichen Aufbauweisen bekannt. Die Erfindung bezieht sich in erster Linie auf elektronische Bauelemente mit einer Aufbauweise, wie sie exemplarisch in der DE 103 10 260 A1 der Anmelderin beschrieben ist. Bei dieser Art von elektronischen Bauelementen ist ein als Halbleiterchip ausgeführter, integrierter Schaltkreis vorgesehen, der über Bonddrähte mit einem Kontaktkörper verbunden ist. Die Bonddrähte stellen eine elektrisch leitende Verbindung mit dem elektrisch leitend ausgeführten Kontaktkörper her. Der Kontaktkörper weist zumindest eine äußere Kontaktfläche auf, die für eine Kontaktierung einer Oberfläche, beispielsweise einer als gedruckte Schaltung (PCB - Printed Circuit Board) ausgeführten Leiterplatte vorgesehen ist. Die integrierte Schaltung, die Bonddrähte und der Kontaktkörper sind in eine schützende Masse, typischerweise in ein Epoxidharz, vergossen, um Umwelteinflüsse auf die integrierte Schaltung und die Bondverbindungen zu minimieren. Ein solches Bauelement kann beispielsweise nach den Standards JDEC JC-11, M0 - 220 four side, M0 - 2209 two side (Anschlussseiten) definiert sein und wird als Quad flat Non-Lead Bauteil bezeichnet. Andere Gehäusebauformen oder Aufbauweisen für elektronische Bauelemente werden ebenfalls von der Erfindung umfasst.

Der Erfindung liegt die Aufgabe zugrunde, ein elektronisches Bauelement, eine elektronische Baugruppe und ein Verfahren zur Herstellung elektronischer Baugruppen zu schaffen, die eine flexiblere Verwendbarkeit und eine erhöhte Funktionssicherheit aufweisen.

Diese Aufgabe wird gemäß einem ersten Aspekt der Erfindung durch ein elektronisches Bauelement der eingangs genannten Art gelöst, bei dem an dem Kunststoffgehäuse zumindest eine, insbesondere als Vertiefung ausgeführte, Ausnehmung vorgesehen ist, in der zumindest eine Kontaktzunge freiliegend angeordnet ist. In die Ausnehmung kann ein Elektronikbauteil, insbesondere ein Sensorelement, eingesetzt und mit der im elektronischen Bauelement untergebrachten integrierten Schaltung über die zumindest eine Kontaktzunge elektrisch leitend verbunden werden. Für eine elektrische Ankopplung an die zumindest eine Kontaktzunge weist das Elektronikbauteil zumindest eine, vorzugsweise metallische, Kontaktfläche auf, die mit der Kontaktzunge mittels eines der nachstehend genannten Kontaktierungsverfahren verbunden werden kann. Für die elektrische und mechanische Kopplung des Elektronikbauteils mit dem elektronischen Bauelement muss keine zusätzliche Einheit wie eine Leiterplatte eingesetzt werden. Vielmehr wird das Elektronikbauteil direkt in die Ausnehmung eingesetzt und elektrisch kontaktiert. Vorzugsweise ist die Ausnehmung auf die Größe des Elektronikbauteils abgestimmt und erlaubt eine im Wesentlichen vollständige Aufnahme des Elektronikbauteils, so dass dieses vorzugsweise bündig mit einer Außenoberfläche des elektronischen Bauelements abschließt. Die Schaffung einer elektrischen Verbindung zwischen dem Elektronikbauteil und der zumindest einen, in die Ausnehmung hineinragenden Kontaktzunge kann insbesondere durch Löten, Bonden, Leitkleben, Laserlöten, Laserschweissen, verwirklicht werden. Mit dieser unmittelbaren Ankopplung des Elektronikbauteils an die integrierte Schaltung wird eine vorteilhafte elektrische Verbindung verwirklicht, die sich gegenüber einer Kopplung mit einer zwischengeschalteten Leiterplatte insbesondere durch deutlich reduzierte Übergangswiderstände und Streukapazitäten auszeichnet. Bei Verwendung einer Leiterplatte zur Kopplung des Elektronikbauteils mit dem elektronischen Bauelement muss jede elektrische Verbindung über die Leiterplatte geführt werden, so dass sowohl vom Elektronikbauteil als auch vom elektronischen Bauelement jeweils eine Kontaktstelle mit der Leiterplatte verwirklicht werden muss. Zur Verbindung der Kontaktstellen müssen in der Leiterplatte Kupferleitbahnen werden. Da jede Kontaktstelle ein Risiko einer fehlerhaften elektrischen Verbindung mit sich bringt und die Kupferbahnen in der Leiterplatte schadhaft oder falsch verdrahtet sein können, ergibt sich durch die erfindungsgemäße, unmittelbare Kopplung des Elektronikbauteils mit den Kontaktzungen des elektronischen Bauelements eine erhebliche Verbesserung der Funktionssicherheit einer dadurch bestimmten elektronischen Baugruppe. Zudem kann die das Elektronikbauteil und das elektronische Bauelement umfassende elektronische Baugruppe aufgrund der geringeren Anzahl von herzustellenden elektrischen Verbindungen und aufgrund des Verzichts auf eine Leiterplatte kostengünstiger hergestellt werden.

In Ausgestaltung der Erfindung ist vorgesehen, dass an zumindest einer Außenfläche des Kunststoffgehäuses abseits der Ausnehmung zumindest eine freiliegende Kontaktzunge vorgesehen ist, die insbesondere für eine elektrisch leitfähige Oberflächenmontage gestaltet ist. Mit der zumindest einen abseits der Ausnehmung und somit nicht für eine unmittelbare elektrische Anbindung eines Elektronikbauteils vorgesehenen Kontaktzunge kann das elektronische Bauelement bei Anordnung auf einer Leiterplatte mit einer Kontaktfläche der Leiterplatte elektrisch verbunden werden. Dies ermöglicht beispielsweise eine Versorgung des elektrischen Bauelements mit einer elektrischen Spannung und/oder die Zu- und/oder Ableitung elektrischer Signale zu einer mit der Leiterplatte gekoppelten Ansteuer- und/oder Auswerteeinheit. Damit kann das elektronische Bauelement in bekannter Weise in einen elektronischen Schaltungsaufbau integriert werden, wie er insbesondere für Steuergeräte im Kraftfahrzeugbereich bekannt ist.

In weiterer Ausgestaltung der Erfindung ist vorgesehen, dass ausschließlich in der Ausnehmung des Kunststoffgehäuses freiliegende Kontaktzungen angeordnet sind. Bei dieser Ausführungsform der Erfindung ist das elektronische Bauelement nicht für eine elektrische Ankopplung an eine Leiterplatte vorgesehen, sondern vielmehr autark gestaltet und vorzugsweise kontaktlos ansteuerbar ausgeführt. Eine Versorgung mit elektrischer Leistung kann entweder durch eine im elektronischen Bauelement integrierte Spannungsversorgung oder durch Einkopplung eines äußeren Energiefeldes, beispielsweise eines elektrischen Feldes, in das elektronische Bauelement stattfinden. Eine Zu- und/oder Ableitung elektrischer Signale zum und/oder vom elektronischen Bauelement erfolgt ebenfalls kontaktlos, beispielsweise über die Veränderung des eingestrahlten elektrischen Feldes oder durch aktive Aussendung eines Signals durch das elektronische Bauelement. Damit kann eine aus dem elektronischen Bauelement und einem Elektronikbauteil gebildete elektronische Baugruppe besonders flexibel auch an Orten eingesetzt werden, an denen eine kontaktgebundene Energieversorgung und eine kontaktgebundene Zu- und/oder Ableitung elektrischer Signale aufwendig oder unmöglich wäre.

In weiterer Ausgestaltung der Erfindung ist vorgesehen, dass die Ausnehmung zumindest abschnittsweise als Durchbruch oder Ausbruch gestaltet ist, in dem zumindest eine in der Ausnehmung vorgesehene Kontaktzunge vom Kunststoffgehäuse freigestellt angeordnet ist. Damit kann eine besonders flexible Anbringung eines Elektronikbauteils in der Ausnehmung vorgenommen werden. Ein Durchbruch im Kunststoffgehäuse des elektronischen Bauelements ermöglicht eine Anbringung des Elektronikbauteils von einer Ober- oder einer Unterseite des elektronischen Bauelements. Bei einer geeigneten Gestaltung des Durchbruchs und der Kontaktzungen ist auch eine beidseitige Anbringung von Elektronikbauteilen am elektronischen Bauelement möglich. In einen Ausbruch, also einer als Einbuchtung in einer Stirnseite des Kunststoffgehäuses gestalteten Ausnehmung, kann ein Elektronikbauteil angebacht werden, das beispielsweise als Sensorelement ausgeführt ist und das an mehr als einer Außenoberfläche eine aktive Sensorfläche aufweist.

In weiterer Ausgestaltung der Erfindung ist vorgesehen, dass die Ausnehmung als Durchbruch gestaltet ist und die zumindest eine Kontaktzunge als freitragender Steg oder als brückenartiger Steg ausgeführt ist, wobei das Kunststoffgehäuse die Ausnehmung, insbesondere rahmenartig, umfasst. Damit kann eine Anbringung des Elektronikbauteils von zwei gegenüberliegenden Seiten des Kunststoffgehäuses vorgenommen werden. Eine elektrische Kontaktierung des Elektronikbauteils mit den freitragenden oder brückenartig ausgeführten Kontaktzungen ermöglicht eine besonders vorteilhafte Gestaltung der elektrischen Verbindungen. Eine als freitragender Steg ausgeführte Kontaktzunge ist einseitig an dem Kunststoffgehäuse angebracht und ragt in den Durchbruch hinein. Eine brückenartig ausgeführte Kontaktzunge ist jeweils an zwei gegenüberliegenden Endbereichen im Kunststoffgehäuse aufgenommen und ermöglicht eine stabile, zu Übertragung von Kräften geeignete Verbindung zwischen Kunststoffgehäuse und Elektronikbauteil.

Gemäß einem weiteren Aspekt der Erfindung ist eine elektronische Baugruppe vorgesehen, die ein elektronisches Bauelement und zumindest ein Elektronikbauteil aufweist, wobei das zumindest eine Elektronikbauteil elektrisch an die zumindest eine, in der Ausnehmung vorgesehene, Kontaktzunge angekoppelt ist und mit einer Vergussmasse vergossen ist, die das Elektronikbauteil zumindest teilweise umgibt. Die Vergussmasse stellt eine vorteilhafte mechanische und gegebenenfalls auch thermische und/oder elektrische Anbindung zwischen Kunststoffgehäuse und Elektronikbauteil sicher. Die Vergussmasse verhindert zudem ein Einwirken von Umwelteinflüssen wie beispielsweise Feuchtigkeit auf die elektrischen Verbindungen zwischen dem Elektronikbauteil und den Kontaktzungen.

In weiterer Ausgestaltung der Erfindung ist vorgesehen, dass die Ausnehmung als formschlüssige Kupplungsstruktur ausgebildet ist, die für eine lagerichtige Positionierung des zumindest abschnittsweise korrespondierend zur Kupplungsstruktur gestalteten, elektrisch mit der zumindest einen Kontaktzunge verbindbaren, Elektronikbauteils vorgesehen ist. Damit kann eine einfache und zuverlässige Ausrichtung des Elektronikbauteils gegenüber dem Kunststoffgehäuse verwirklicht werden. Bei einer bevorzugten Ausführungsform der Erfindung ist die Ausnehmung zumindest abschnittsweise mit einem Hinterschnitt, insbesondere in der Art einer Schwalbenschwanzführung, versehen. Dies ermöglicht die Verwirklichtung einer mechanischen Codierung zwischen Ausnehmung und Elektronikbauteil, bei der das Elektronikbauteil nur in genau einer vorgebbaren, präzise reproduzierbaren Position in die Ausnehmung eingebaut werden kann.

In weiterer Ausgestaltung der Erfindung ist vorgesehen, dass die Vergussmasse derart gewählt ist, dass das Elektronikbauteil in der Ausnehmung im Wesentlichen frei von mechanischen Eigenspannungen eingebettet ist. Das Elektronikbauteil, das typischerweise ein Sensor zur Ermittlung einer Messgröße ist, wird somit auch bei Verwendung eines mechanisch-elektrischen Messprinzips, wie es insbesondere bei einem Deformationssensor wie einem Dehnmessstreifen verwendet wird, durch die Vergussmasse nicht in negativer Weise hinsichtlich seiner Messgenauigkeit beeinflusst. Eine Bereitstellung exakter Messwerte wird somit nur unwesentlich durch die mechanischen Eigenschaften der Vergussmasse, insbesondere der temperaturabhängigen Ausdehnung, beeinflusst.

In weiterer Ausgestaltung der Erfindung ist vorgesehen, dass die Vergussmasse ein Silikongel ist, das im ausgehärteten Zustand eine auf das Elektronikbauteil angepasste Shore-Härte kleiner 60, besonders bevorzugt kleiner 40, insbesondere kleiner 30, und damit eine auf den Sensortyp bzw. Aktuatortyp angepasste Shore-Härte aufweist. Bevorzugt ist eine Shore-Härte (Shore A, 20 Grad Celsius) kleiner 60, besonders bevorzugt kleiner 40, insbesondere kleiner 30 vorgesehen. Damit ist sichergestellt, dass mechanische Eigenspannungen, die durch die Vergussmasse hervorgerufen werden, deutlich kleiner sind als die ohnehin im Gehäuse des Elektronikbauteils auftretenden Eigenspannungen und somit nicht zu einer unerwünschten Veränderung der Eigenschaften des Elektronikbauteils führen.

In weiterer Ausgestaltung der Erfindung ist vorgesehen, dass das Elektronikbauteil ein Drucksensor, insbesondere zur Ermittlung eines Flüssigkeits- oder Gasdrucks, ist. Das Elektronikbauteil kann somit beispielsweise als Drucksensor für ein Reifendruck-Überwachungssystem (Tire Pressure Measurement System - TPMS) eingesetzt werden.

In weiterer Ausgestaltung der Erfindung ist vorgesehen, dass dem Drucksensor ein weiteres, als Bewegungssensor und/oder als Beschleunigungssensor ausgeführtes Elektronikbauteil zugeordnet ist. Mit einem vorzugsweise in der gleichen Ausnehmung oder in einer weiteren Ausnehmung am elektronischen Bauelement angebrachten Bewegungs- und/oder Beschleunigungssensor kann ein vom Drucksensor ermitteltes Messergebnis in Korrelation mit einer Bewegung des Reifens, in dem das Reifendruck-Überwachungssystem installiert ist, gebracht werden. Vorzugsweise ist der Bewegungssensor in der Lage, eine Rotationsrichtung des Reifens zu detektieren. Bei einem Druckverlust im Reifen während der Fahrt kann somit vom Drucksensor eine Warnmeldung erzeugt werden, die an ein Steuergerät oder unmittelbar an ein Anzeigegerät weitergeleitet wird.

In weiterer Ausgestaltung der Erfindung ist vorgesehen, dass die integrierte Schaltung oder das Elektronikbauteil als RFID-Einheit und/oder als Signalprozessor und/oder als Speichereinheit gestaltet ist. Mit einer RFID-Einheit kann eine kontaktlose Signalübertragung, insbesondere von Messdaten eines Sensors, vorgenommen werden. Vorzugsweise ist dem Sensor ein Signalprozessor zugeordnet, der eine Aufbereitung, insbesondere eine Digitalisierung, der ermittelten Messwerte ermöglicht. Eine Speichereinheit ermöglicht das zeitweilige, flüchtige oder unlöschbare Ablegen von Messwerten.

Gemäß einem weiteren Aspekt der Erfindung ist ein Verfahren zur Herstellung einer elektronischen Baugruppe mit folgenden Schritten vorgesehen: Erstellen zumindest einer elektrischen Verbindung zwischen einer integrierten Schaltung und zumindest einer Kontaktzunge, insbesondere durch Bonden; Ummanteln der integrierten Schaltung, der elektrischen Verbindungen und der Kontaktzunge mit einer härtbaren Vergussmasse zur Bildung eines formstabilen Kunststoffgehäuses in einer Vergussform, wobei beim Vergussvorgang eine Ausnehmung im Kunststoffgehäuse freigestellt bleibt, in der zumindest eine Kontaktzunge freiliegend angeordnet ist. Mit diesem Verfahren wird ein elektronisches Bauelement hergestellt, das für die Montage eines oder mehrerer unmittelbar an den Kontaktzungen kontaktierbarer Elektronikbauteile vorbereitet ist. Dabei können mehrere Kontaktzungen zu einem Kontaktkörper, der auch als Leadframe bezeichnet wird, zusammengefasst werden. Der Leadframe weist einen umlaufenden Rahmen auf, an dem die Kontaktzungen angebracht sind und der in einem späteren Arbeitsschritt abgetrennt wird, um elektrisch voneinander isolierte Kontaktzungen zu verwirklichen. Die insbesondere als Silizium-Die verwirklichte integrierte Schaltung weist typischerweise an einer Unterseite eine Massefläche auf und ist an einer Oberseite mit Bondpads versehen, die eine stoffschlüssige Anbringung von Aluminium- oder Golddraht-Bonddrähten ermöglicht, die mit den Kontaktzungen verbunden werden. Die Vergussmasse, die zur Schaffung des Kunststoffgehäuses eingesetzt wird, bettet die integrierte Schaltung, die elektrischen Verbindungen sowie bereichsweise auch die Kontaktzungen stoffschlüssig ein und bewirkt damit eine Kapselung vor Umwelteinflüssen.

In weiterer Ausgestaltung der Erfindung sind die folgenden weiteren Schritte vorgesehen: Einbringen zumindest eines Elektronikbauteils in die Ausnehmung des elektronischen Bauelements; Herstellung einer elektrisch leitendenden Verbindung zwischen dem Elektronikbauteil und zumindest einer in der Ausnehmung angeordneten, freiliegenden Kontaktzunge; Einbetten des zumindest einen Elektronikbauelements in die Ausnehmung mit einer härtbaren, insbesondere spannungsarm aushärtenden, Vergussmasse. Das Elektronikbauteil wird durch eines der vorstehend genannten Kontaktierungsverfahren elektrisch auf dem kürzesten Weg, der für zwei diskrete, separat voneinander ausgeführte Bauelemente möglich ist, mit der integrierten Schaltung verbunden. Eine direktere Kopplung der Bauelemente ist nur möglich, wenn die beiden Bauelemente direkt miteinander verbunden werden, wie dies typischerweise bei Multichip-Modulen verwirklicht werden kann. Derartige Multichip-Module weisen jedoch bei Weitem nicht die flexible Einsetzbarkeit auf, die mit einem elektrischen Bauteil und einem daran anbringbaren, diskreten Elektronikbauteil verwirklicht werden kann.

Weitere Vorteile und Merkmale der Erfindung ergeben sich aus den Ansprüchen sowie aus der nachfolgenden Beschreibung bevorzugter Ausführungsbeispiele, die anhand der Zeichnungen dargestellt sind. Dabei zeigt:
- Fig. 1: eine perspektivische Draufsicht auf eine erste Ausführungsform einer elektronischen Baugruppe,
- Fig. 2: eine perspektivische Ansicht von unten auf die elektronische Baugruppe,
- Fig. 3: eine ebene Draufsicht auf die elektronische Baugruppe,
- Fig. 4: eine ebene Seitenansicht auf die elektronische Baugruppe,
- Fig. 5: eine ebene Ansicht von unten auf die elektronische Baugruppe,
- Fig. 6: eine perspektivische Darstellung einer zweiten Ausführungsform eines elektronischen Bauelements,
- Fig. 7: eine perspektivische Darstellung eines auf das elektronische Bauelement der Fig. 7 angepassten Elektronikbauteils.

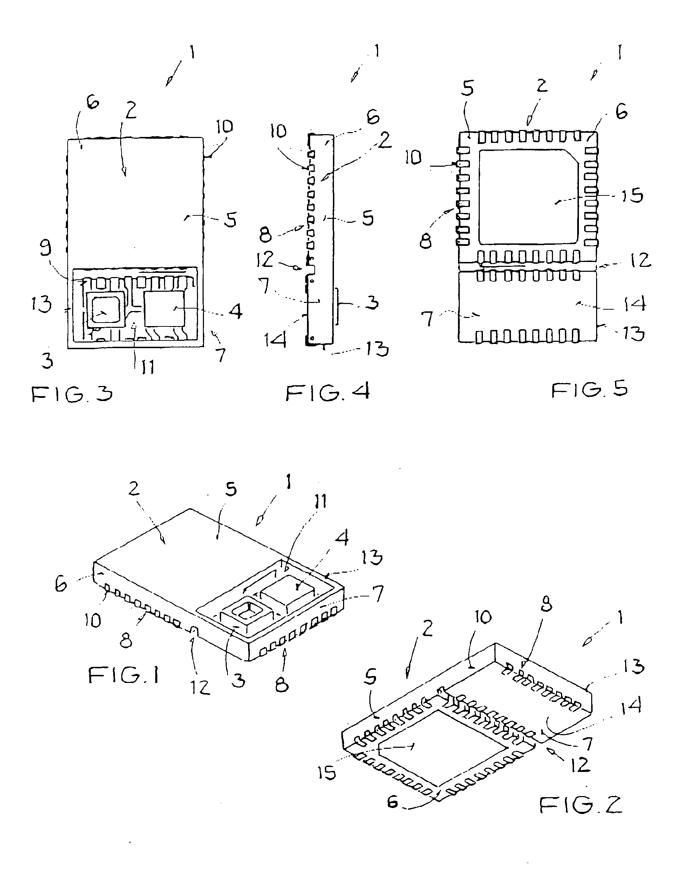

Die Figuren 1 bis 5 zeigen eine elektronische Baugruppe 1, die aus einem elektronischen Bauelement 2 und zwei Elektronikbauteilen 3, 4 aufgebaut ist. Die elektronische Baugruppe 1 ist in einem formstabilen Kunststoffgehäuse 5 aufgenommen, das exemplarisch aus einem QFN-Gehäuse 6 des Typs QFN_5x8_32L und einem einstückig daran angebrachten, erfindungsgemäßen Erweiterungsbereich 7 aufgebaut ist. Die Zahlenwerte besagen, dass das QFN-Gehäuse eine Kantenlänge von 5mm mal 8mm aufweist und mit 32 Kontakten versehen ist.

Der Erweiterungsbereich 7 dient zur Aufnahme der zwei diskreten Elektronikbauteile 3, 4, die in den Fig. 1 und 3 näher dargestellt sind. Im QFN-Gehäuse 6 ist eine nicht näher dargestellte integrierte Schaltung enthalten, die elektrisch leitend mit elektrisch leitfähigen, von außen am Kunststoffgehäuse 5 zugänglichen Kontaktzungen verbunden ist. Eine größere Anzahl von Kontaktzungen ist als Lötpads 8 an einem umlaufenden Randbereich 10 des QFN-Gehäuses 6 und des Erweiterungsbereichs 7 gestaltet und ist für eine Oberflächenmontage des Kunststoffgehäuses 5 auf eine nicht dargestellte Leiterplatte vorgesehen. Flächenzentrisch an der Unterseite des QFN-Gehäuses 6 ist eine Wärmeleitfläche 15 vorgesehen, die eine Wärmeableitung von der integrierten Schaltung in eine Umgebung oder vorzugsweise an eine thermisch angekoppelte, nicht dargestellte Leiterplatte gewährleistet. Zwischen dem QFN-Gehäuse 6 und dem Erweiterungsbereich 7 ist eine Trennnut 12 vorgesehen, die eine zuverlässige Verlötung der mit geringem Abstand gegenüberliegend angeordneten Lötpads 8 des QFN-Gehäuses 6 und des Erweiterungsbereichs 7 gewährleistet, ohne dass beim Lötvorgang durch Kapillarwirkung oder andere Effekte unerwünschte Lötbrücken zwischen den gegenüberliegenden Lötpads 8 entstehen.

Einige der Kontaktzungen ragen in eine im Erweiterungsbereich 7 vorgesehene, als Vertiefung ausgeführte Ausnehmung 11 hinein, die schachtförmig und rechteckig gestaltet ist. Die Ausnehmung 11 nimmt ein erhebliches Volumen des Erweiterungsbereichs 7 ein und erstreckt sich bis an das QFN-Gehäuse 6 heran. Der Erweiterungsbereich 7 besteht somit im Wesentlichen aus einem umlaufenden Rand 13 und einem Bodenbereich 14, der die Ausnehmung 11 nach unten verschließt und als Auflagefläche für die als Kontaktbereiche 9 ausgeführten Kontaktzungen dient. Die Kontaktbereiche 9 ermöglichen eine Oberflächenmontage der Elektronikbauteile 3, 4 mit bekannten Kontaktierungsverfahren wie Löten, Leitkleben oder Laserlöten. Die Kontaktbereiche 9 liegen auf dem Bodenbereich 14 auf und sind daher vorteilhaft abgestützt. Die Elektronikbauteile 3, 4 sind als Drucksensor und als Beschleunigungssensor ausgeführt und ermöglichen somit beispielsweise die dynamische Ermittlung eines Reifendrucks in einem Kraftfahrzeug. Die integrierte Schaltung ist als Signalprozessor mit Speichereinheit und RFID-Einheit gestaltet und ermöglicht die Aufbereitung, Speicherung und kontaktlose Übermittlung der Messignale des Drucksensors und des Beschleunigungssensors. Durch die Aufnahme der Elektronikbauteile 3, 4 in der Ausnehmung 11 kann eine flexible Herstellungsweise der elektronischen Baugruppe 1 gewährleistet werden, da beispielsweise für unterschiedliche Reifen unterschiedliche Drucksensoren, insbesondere für unterschiedliche Drücke, eingesetzt werden müssen. Alle Drucksensoren benötigen jedoch eine nachgeschaltete Signalverarbeitung, - speicherung und -übertragung, die in der integrierten Schaltung verwirklicht werden kann. Somit können in einem ersten Arbeitsschritt identische elektronische Bauelemente 2 mit jeweils gleicher integrierter Schaltung vorbereitet werden, die in einem nachfolgenden Arbeitsschritt mit den jeweils bedarfsgerecht angepassten Druck- und Beschleunigungssensoren bestückt werden und damit elektronische Baugruppen 1 mit unterschiedlichen Eigenschaften ergeben. Die Elektronikbauteile 3, 4 werden nach der Kontaktierung mit den Kontaktflächen 9 mit einer nicht dargestellten Vergussmasse vergossen, die vorzugsweise als 2-Komponentensystem aus einem Binder und einem Härter ausgewählt ist und somit ohne äußere Einflüsse wie erhöhte Temperatur oder ultraviolette Strahlung aushärten kann. Die Vergussmasse ist vorzugsweise auch so gewählt, dass sie geringe Eigenspannungen und eine hohe Flexibilität aufweist, um bei Temperaturschwankungen die Ausübung mechanischer Spannungen auf die Elektronikbauteile 3 und 4 zu vermeiden.

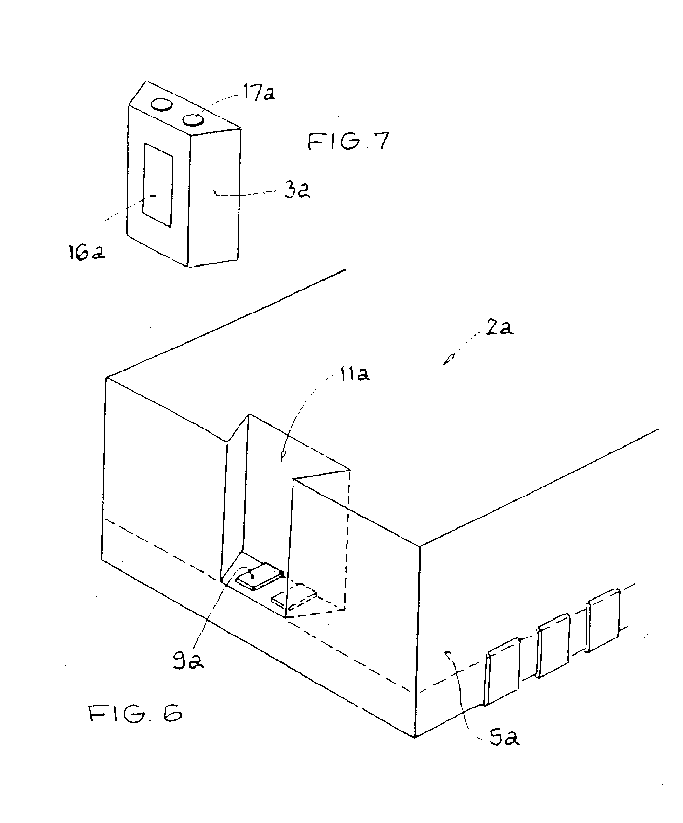

Bei dem in Fig. 6 dargestellten elektronischen Bauelement 2a ist die Ausnehmung 11a im Kunststoffgehäuse 5a als formschlüssige Kupplungsstruktur ausgebildet, die für eine lagerichtige Positionierung des Elektronikbauteils 3a gestaltet ist. Am Elektronikbauteil 3a, das als Drucksensor mit einer stirnseitigen Sensorfläche 16a ausgeführt ist, sind an einer Oberseite gemäß der Fig. 7 zwei Kontaktfelder 17a vorgesehen, die für einen elektrischen Kontakt mit den Kontaktflächen 9a vorgesehen sind, die in der Ausnehmung 11a angeordnet sind. Durch die schwalbenschwanzförmige Kontur der Ausnehmung 11 a kann das Elektronikbauteil 3a nur lagerichtig an dem elektronischen Bauelement 2a montiert werden und ermöglicht somit einen zuverlässigen Herstellungsprozess.

### Bezugszeichenliste

- 1.: elektronische Baugruppe
- 2.: elektronisches Bauelement (a)
- 3.: Elektronikbauteil (a)
- 4.: Elektronikbauteil
- 5.: Kunststoffgehäuse (a)
- 6.: QFN-Gehäuse
- 7.: Erweiterungsbereich
- 8.: Lötpads
- 9.: Kontaktfläche (a)
- 10.: Randbereich
- 11.: Ausnehmung (a)
- 12.: Trennnut
- 13.: Rand
- 14.: Bodenbereich
- 15.: Wärmeleitfläche
- 16.: Sensorfläche (a)
- 17.: Kontaktfeld (a)

## Patentansprüche

1. Elektronisches Bauelement (2, 2a) mit zumindest einer integrierten Schaltung, die in einem formstabilen Kunststoffgehäuse (5, 5a) aufgenommen ist und die elektrisch leitend mit zumindest einer elektrisch leitfähigen, von außen am Kunststoffgehäuse (5, 5a) zugänglichen Kontaktzunge (8, 9, 9a) verbunden ist, **dadurch gekennzeichnet, dass** an dem Kunststoffgehäuse (5, 5a) zumindest eine, insbesondere als Vertiefung ausgeführte, Ausnehmung (11, 11a) vorgesehen ist, in der zumindest eine Kontaktzunge (8, 9, 9a) freiliegend angeordnet ist.

2. Elektronisches Bauelement nach Anspruch 1, **dadurch gekennzeichnet, dass** an zumindest einer Außenfläche des Kunststoffgehäuses (5, 5a) abseits der Ausnehmung (11, 11a) zumindest eine freiliegende Kontaktzunge (8) vorgesehen ist, die insbesondere für eine elektrisch leitfähige Oberflächenmontage gestaltet ist.

3. Elektronisches Bauelement nach Anspruch 1, **dadurch gekennzeichnet, dass** ausschließlich in der Ausnehmung (11, 11a) des Kunststoffgehäuses freiliegende Kontaktzungen (9, 9a) angeordnet sind.

4. Elektronisches Bauelement nach einem der vorhergehenden Ansprüche, **dadurch gekennzeichnet, dass** die Ausnehmung (11, 11a) zumindest abschnittsweise als Durchbruch oder Ausbruch gestaltet ist, in dem zumindest eine in der Ausnehmung vorgesehene Kontaktzunge (9, 9a) vom Kunststoffgehäuse (5, 5a) freigestellt angeordnet ist.

5. Elektronisches Bauelement nach einem der Ansprüche 1 bis 3, **dadurch gekennzeichnet, dass** die Ausnehmung (11, 11a) als Durchbruch oder Ausbruch gestaltet ist und die zumindest eine Kontaktzunge (9, 9a) als freitragender Steg oder als brückenartiger Steg ausgeführt ist, wobei das Kunststoffgehäuse (5, 5a) die Ausnehmung (11, 11 a), insbesondere rahmenartig, umfasst.

6. Elektronische Baugruppe (1) mit einem elektronischen Bauelement (2, 2a) nach einem der vorhergehenden Ansprüche und zumindest einem Elektronikbauteil (3, 3a, 4, 4a), **dadurch gekennzeichnet, dass** das zumindest eine Elektronikbauteil (3, 3a, 4, 4a) elektrisch an die zumindest eine in der Ausnehmung (11, 11 a) vorgesehene Kontaktzunge (8, 9, 9a) angekoppelt ist und mit einer Vergussmasse vergossen ist, die das Elektronikbauteil (3, 3a, 4, 4a) zumindest teilweise umgibt.

7. Elektronische Baugruppe nach Anspruch 7, **dadurch gekennzeichnet, dass** die Ausnehmung (11, 11a) als formschlüssige Kupplungsstruktur ausgebildet ist, die für eine lagerichtige Positionierung des zumindest abschnittsweise korrespondierend zur Kupplungsstruktur gestalteten, elektrisch mit der zumindest einen Kontaktzunge (9, 9a) verbindbaren, Elektronikbauteils (3, 3a, 4, 4a) vorgesehen ist.

8. Elektronische Baugruppe nach Anspruch 7, **dadurch gekennzeichnet, dass** die Vergussmasse derart gewählt ist, dass das Elektronikbauteil (3, 3a, 4, 4a) in der Ausnehmung (11, 11a) im Wesentlichen frei von mechanischen Eigenspannungen eingebettet ist.

9. Elektronische Baugruppe nach Anspruch 8, **dadurch gekennzeichnet, dass** die Vergussmasse ein Silikongel ist, das im ausgehärteten Zustand eine auf das Elektronikbauteil angepasste Shore-Härte kleiner 60, besonders bevorzugt kleiner 40, insbesondere kleiner 30, aufweist.

10. Elektronische Baugruppe nach einem der Ansprüche 6 bis 9, **dadurch gekennzeichnet, dass** das Elektronikbauteil (3, 3a, 4, 4a) ein Drucksensor, insbesondere zur Ermittlung eines Gasdrucks, ist.

11. Elektronische Baugruppe nach Anspruch 10, **dadurch gekennzeichnet, dass** dem Drucksensor ein weiteres, als Bewegungssensor und/oder als Beschleunigungssensor ausgeführtes Elektronikbauteil (3, 3a, 4, 4a) zugeordnet ist.

12. Elektronische Baugruppe nach einem der Ansprüche 6 bis 11, **dadurch gekennzeichnet, dass** die integrierte Schaltung oder das Elektronikbauteil (3, 3a, 4, 4a) als RFID-Einheit und/oder als Signalprozessor und/oder als Speichereinheit gestaltet ist.

13. Verfahren zur Herstellung einer elektronischen Baugruppe (1) mit den Schritten: Erstellen zumindest einer elektrischen Verbindung zwischen einer integrierten Schaltung und zumindest einer Kontaktzunge (8, 9, 9a), insbesondere durch Bonden; Ummanteln der integrierten Schaltung, der elektrischen Verbindungen und der Kontaktzunge (8, 9, 9a) mit einer härtbaren Vergussmasse zur Bildung eines formstabilen Kunststoffgehäuses (5, 5a) in einer Vergussform, wobei beim Vergussvorgang eine Ausnehmung (11, 11a) im Kunststoffgehäuse (5, 5a) freigestellt bleibt, in der zumindest eine Kontaktzunge (9, 9a) freiliegend angeordnet ist.

14. Verfahren zur Herstellung einer elektronischen Baugruppe nach Anspruch 13, **gekennzeichnet durch** die weiteren Schritte: Einbringen zumindest eines Elektronikbauteils (3, 3a, 4, 4a) in die Ausnehmung (11, 11a) des elektronischen Bauelements (2, 2a); Herstellung einer elektrisch leitendenden Verbindung zwischen dem Elektronikbauteil (3, 3a, 4, 4a) und zumindest einer in der Ausnehmung (11, 11a) angeordneten, freiliegenden Kontaktzunge (11, 11 a); Einbetten des zumindest einen Elektronikbauelements (3, 3a, 4, 4a) in die Ausnehmung (11, 11a) mit einer härtbaren, insbesondere spannungsarm aushärtenden, Vergussmasse.
